# EUROPÄISCHE PATENTSCHRIFT

(11) **EP 1 262 095 B1**
(45) Veröffentlichungstag und Bekanntmachung des Hinweises auf die Patenterteilung: **22.09.2004**
(21) Anmeldenummer: 01951200.3
(22) Anmeldetag: 25.01.2001
(51) Int. Cl.: H05K 7/20, H02B 1/56, G06F 1/20

(54) **LUFTDURCHTRITTSEINRICHTUNG**
DEVICE FOR THE PASSAGE OF AIR
DISPOSITIF D'AERATION

(30) Priorität: 07.02.2000 DE 20002124 U
(43) Veröffentlichungstag der Anmeldung: 04.12.2002
(73) Patentinhaber: Pfannenberg GmbH, 21035 Hamburg (DE)
(72) Erfinder: PFANNENBERG, Andreas, 21035 Hamburg (DE)
(74) Vertreter: Richter, Joachim, Dipl.-Ing.
(86) Internationale Anmeldenummer: PCT/EP2001/000807
(87) Internationale Veröffentlichungsnummer: WO 2001/060137

(56) Entgegenhaltungen:
- EP-A- 0 439 667
- DE-A- 19 641 553
- DE-U- 29 917 735
- FR-A- 2 704 366
- US-A- 5 822 186

## Beschreibung

Die Erfindung betrifft eine Luftdurchtrittseinrichtung, insbesondere Filterlüfter oder Austrittsfilter, für den Einbau in eine Durchbrechung in einer Wand eines Gehäuses, insbesondere eines Gehäuses von Abwärme erzeugenden Bauteilen, eines Elektronikschrankes, eines Schaltschrankes, eines Gehäusesystems oder eines Computergehäuses, wobei die Luftdurchtrittseinrichtung folgendes umfasst, ein Grundgehäuse, ein in bzw. an dem Grundgehäuse klemmend gehaltenes Abdeckgehäuse und eine in dem Abdeckgehäuse gehaltene Filtermatte, wobei das Grundgehäuse wenigstens ein Federelement zum Eingriff in die Durchbrechung der Wand des Gehäuses aufweist, gemäß. dem Oberbegriff des Anspruchs 1.

Bei in einem Gehäuse angeordneten Bauteilen, welche entsprechende Abwärme erzeugen, ist es notwendig, die Abwärme aus dem Gehäuse abzuführen und eine Temperatur in dem Gehäuse durch mehr oder weniger starkes Einblasen oder Absaugen von Umgebungsluft in den Gehäuseinnenraum mittels des Lüfters zu kontrollieren. Ein bekanntes Beispiel hierfür sind Computergehäuse, wobei hier der Leitsatz gilt, je mehr Kühlung desto besser. Üblicherweise werden derartige Gehäuse mit einem Filterlüfter versehen, welcher entweder ständig läuft oder von einer Steuerung in Abhängigkeit von einer Temperatur im Gehäuse an- und abgeschaltet wird. Der Filterlüfter ist in einer Ausnehmung einer Wandung des Gehäuses angeordnet und beispielsweise mittels Schraubverbindungen fixiert. Gleichzeitig sind an einer anderen Stelle des Gehäuses für einen Luftaustritt entsprechende Luftaustrittsschlitze vorgesehen. Die Montage derartiger Filterlüfter ist jedoch oftmals mühevoll, da bei der Anwendung von Schraubverbindungen kaum Spielraum zur Verfügung steht, um den Filterlüfter auch noch nachträglich optisch ausrichten zu können. Auch können keine großen Spannbreiten überbrückt werden, um verschiedene Blechstärken der Montagewände zu berücksichtigen.

Die EP-A-0439667 offenbart bereits eine Luftdurchtrittseinrichtung für den Einbau in eine Durchbrechung in einer Wand eines Gehäuses, wobei ein Filterlüfter am Grundgehäuse vorgesehene Schnellbefestigungseinrichtungen aufweist, die aus in den Eckbereichen des Rahmens des Grundgehäuses ausgebildeten flügelartigen Klemmabschnitten bestehen, die aus den Rahmen des Grundgehäuses bildenden Seitenwänden in Richtung zu den Eckbereichen flügelartig herausgestellt sind und somit aus der von den Seitenwänden des Rahmens des Grundgehäuses gebildeten Ebene herausragen.

Die DE-U-29917735 betrifft eine Vorrichtung zur Belüftung eines Computergehäuses, bei dem ein Filterelement von einem rahmenartigen Träger gehalten ist. Eine Fixierung des Filterträgers innerhalb der Lüftungsaufnehmung erfolgt mit Hilfe eines Rastelementes, das beispielsweise als eine federnde Zunge ausgeführt sein kann. Der Filterträger weist darüberhinaus Trägerschwenkgelenke auf, die die Durchführung einer Schwenkbewegung des Filterträgers relativ zum Computergehäuse unterstützen. Diese Luftdurchtrittseinrichtung weist jedoch kein Abdeckgehäuse auf.

Die US-A-5822186 offenbart eine Luftdurchtrittseinrichtung, die jedoch kein Abdeckgehäuse mit einer Filtermatte aufweist.

Es ist Aufgabe der vorliegenden Erfindung, eine Luftdurchtrittseinrichtung der oben genannten Art dahingehend zu verbessern, dass die Schnellbefestigung vereinfacht und gleichzeitig eine Ableitung von sich ansammelndem Kondenswasser gewährleistet ist.

Diese Aufgabe wird durch einen Filterlüfter der o. g. Art mit den in den Ansprüchen 1, 2 und 3 gekennzeichneten Merkmalen gelöst.

Dazu ist es erfindungsgemäß nach Anspruch 1 vorgesehen, dass das wenigsten eine Federelement nur an der oberen Seite des Grundgehäuses und an der gegenüberliegenden unteren Seite des Grundgehäuses wenigstens ein Klemmkeil derart angeordnet und ausgebildet sind, dass der bzw. die Klemmkeile und das bzw. die Federelemente zusammenwirkend mit einem umlaufenden Rand der Durchbrechung der Wand des Gehäuses die Luftdurchtrittseinrichtung an der Wand haltern; dass an dem Grundgehäuse gehäuseseitig eine umlaufende Nut zur Aufnahme einer Dichtung derart vorgesehen ist, dass bei in der Durchbrechung angeordnetem Grundgehäuse die Dichtung zwischen der Wand des Gehäuses und dem Grundgehäuse unter einem vorbestimmten Anpressdruck gehalten ist; und dass an einer in Einbaulage der Luftdurchtrittseinrichtung in Schwerkraftrichtung unten liegenden Seite des Grundgehäuses eine Wanne zur Aufnahme von Kondenswasser ausgebildet ist.

Des weiteren ist erfindungsgemäß nach Anspruch 2 vorgesehen, dass das wenigsten eine Federelement nur an der oberen Seite des Grundgehäuses und an der gegenüberliegenden unteren Seite des Grundgehäuses wenigstens ein Klemmkeil derart angeordnet und ausgebildet sind, dass der bzw. die Klemmkeile und das bzw. die Federelemente zusammenwirkend mit einem umlaufenden Rand der Durchbrechung der Wand des Gehäuses die Luftdurchtrittseinrichtung an der Wand haltern, und dass bei in der Durchbrechung angeordnetem Grundgehäuse die Dichtung zwischen der Wand des Gehäuses und dem Grundgehäuse unter einem vorbestimmten Anpressdruck gehalten ist; und dass an einer in Einbaulage der Luftdurchtrittseinrichtung in Schwerkraftrichtung unten liegenden Seite des Grundgehäuses eine Wanne zur Aufnahme von Kondenswasser ausgebildet ist.

Eine dritte erfindungsgemäße Lösung besteht nach Anspruch 3 darin, dass wenigsten eine Federelement nur an der oberen Seite des Grundgehäuses und an der gegenüberliegenden unteren Seite des Grundgehäuses wenigstens ein Klemmkeil derart angeordnet und ausgebildet sind, dass der bzw. die Klemmkeile und das bzw. die Federelemente zusammenwirkend mit einem umlaufenden Rand der Durchbrechung der Wand des Gehäuses die Luftdurchtrittseinrichtung an der Wand haltern, dass an dem Grundgehäuse gehäuseseitig eine umlaufende Nut zur Aufnahme einer Dichtung derart vorgesehen ist, dass bei in der Durchbrechung angeordneten Grundgehäuse die Dichtung zwischen der Wand des Gehäuses und dem Grundgehäuse unter einem vorbestimmten Anpressdruck gehalten ist, und dass an einer in Einbaulage der Luftdurchtrittseinrichtung in Schwerkraftrichtung unten liegenden Seite des Grundgehäuses eine Wanne zur Aufnahme von Kondenswasser ausgebildet ist.

Dies hat den Vorteil, dass im Bereich der Filtermatte ggf. auftretendes Kondenswasser aus dem durchtretenden Luftstrom innerhalb des Grundgehäuses aufgefangen wird, wobei durch die umlaufende Dichtung an dem Grundgehäuse ein Eindringen dieses Kondenswassers in das Gehäuse wirksam vermieden ist. Die Maßnahmen, die für diese Einrichtung ergriffen wurden, dienen nicht nur der Kondenswasserentsorgung, sondern sollen z.B. bei Outdoor-Anwendungen eindringenden Regen nicht an die empfindlichen elektrischen und elektronischen Komponenten gelangen lassen.

Vorteilhafte weitere Ausgestaltungen der erfindungsgemäßen Einrichtung sind Gegenstand der Unteransprüche.

Zum Ausbilden eines Filterlüfters mit durch ein Gebläse erzwungener Luftströmung durch die Luftdurchtrittseinrichtung ist am Grundgehäuse gegenüber des Abdeckgehäuses ein Gebläseträger mit einem Gebläse angeordnet.

Für einen optisch vorteilhaften Abschluss der Luftdurchtrittseinrichtung und zum haltern der Filtermatte ist in besonders vorteilhafter Weise an einer dem Grundgehäuse abgewandten Seite des Abdeckgehäuses ein Designeinsatz angeordnet.

Zum Unterstützen der Abführung von eingedrungenem Wasser aus dem Grundgehäuse befinden sich auf der Rückseite dieses Grundgehäuses Rippen, welche derart abgeschrägt sind, dass sich ein Kondenswasserstrom in Richtung der Wanne im Grundgehäuse einstellt.

Zweckmäßigerweise ist die Dichtung in der Nut des Grundgehäuses eine aufgeschäumte PU-Dichtung.

Für einen ungehinderten und schnellen Abtransport von Drainagewasser aus dem Grundgehäuse in die Wanne weist der Designdeckel an einer der Wanne im Grundgehäuse zugewandten Seite wenigstens eine Durchbrechung bzw. Schlitz auf.

Bevorzugterweise ist die Wanne an einer dem Gehäuse abgewandten Seite des Grundgehäuses und ggf. mit diesem einstückig ausgebildet.

Zweckmäßigerweise ist das Grundgehäuse rechteckig ausgebildet und sind zwei Federelemente an zwei benachbarten Ecken einer Seite des Grundgehäuses angeordnet, welche in Einbaulage der Luftdurchtrittseinrichtung in Schwerkraftrichtung oben liegt, wobei bevorzugt an einer in Einbaulage der Luftdurchtrittseinrichtung in Schwerkraftrichtung unten liegenden Seite des Grundgehäuses zwei oder mehrere Klemmkeile beabstandet von entsprechenden Ecken dieser unten liegenden Seite angeordnet sind.

Zweckmäßigerweise sind das bzw. die Federelemente und der bzw. die Klemmkeile einstückig mit dem Grundgehäuse ausgebildet.

Nachstehend wird die Erfindung anhand der beigefügten Zeichnungen näher erläutert. Diese zeigen in
- Fig. 1: eine erste bevorzugte Ausführungsform einer erfindungsgemäßen Luftdurchtrittseinrichtung in Form eines Filterlüfters in perspektivischer Explosionsdarstellung,
- Fig. 2: in teilweise weggebrochener Aufsicht,
- Fig. 3: in Schnittansicht,
- Fig. 4: ein Abdeckgehäuse der Ausführungsform gemäß Fig. 1 bis 3 in Aufsicht,
- Fig. 5: in einer Schnittansicht entlang Linie A-A von Fig. 4,
- Fig. 6: in einer Schnittansicht entlang Linie B-B von Fig. 4,
- Fig. 7: einen Designeinsatz der Ausführungsform gemäß Fig. 1 bis 3 in Aufsicht,
- Fig. 8: in einer Schnittansicht entlang Linie A-A von Fig. 7,
- Fig. 9: in Detailansicht bzgl. des Bereiches X von Fig. 8,
- Fig. 10.: ein Grundgehäuse der Ausführungsform gemäß Fig. 1 bis 3 in Aufsicht,
- Fig. 11: in einer Schnittansicht entlang Linie B-B von Fig. 10,
- Fig. 12: in einer Schnittansicht entlang Linie A-A von Fig. 10,
- Fig. 13: in Detailansicht bzgl. des Bereiches Y von Fig. 12,
- Fig. 14: ein Grundgehäuse einer zweiten bevorzugten Ausführungsform einer erfindungsgemäßen Luftdurchtrittseinrichtung in Aufsicht,
- Fig. 15: in einer Schnittansicht entlang Linie A-A von Fig. 14,
- Fig. 16: in einer Schnittansicht entlang Linie B-B von Fig. 14,
- Fig. 17: in Detailansicht bzgl. des Bereiches X von Fig. 15,
- Fig. 18: in Detailansicht bzgl. des Bereiches Y von Fig. 14,
- Fig. 19: ein Abdeckgehäuse der zweiten bevorzugten Ausführungsform in Aufsicht,
- Fig. 20: in einer Schnittansicht entlang Linie A-A von Fig. 19,
- Fig. 21: einen Designeinsatz der zweiten bevorzugten Ausführungsform in Aufsicht,
- Fig. 22: in einer Schnittansicht entlang Linie A-A von Fig. 21,
- Fig. 23: in Detailansicht bzgl. des Bereiches X von Fig. 22,
- Fig. 24: in Detailansicht bzgl. des Bereiches Y von Fig. 22,
- Fig. 25: ein Abdeckgehäuse einer dritten bevorzugten Ausführungsform in Aufsicht,
- Fig. 26: in einer Schnittansicht entlang Linie A-A von Fig. 25,
- Fig. 27: einen Designeinsatz der dritten bevorzugten Ausführungsform in Aufsicht,
- Fig. 28: in einer Schnittansicht entlang Linie A-A von Fig. 27,
- Fig. 29: in Detailansicht bzgl. des Bereiches X von Fig. 28,
- Fig. 30: ein Grundgehäuse der dritten bevorzugten Ausführungsform einer erfindungsgemäßen Luftdurchtrittseinrichtung in Aufsicht,
- Fig. 31: in einer Schnittansicht entlang Linie A-A von Fig. 30,
- Fig. 32: in einer Schnittansicht entlang Linie B-B von Fig. 30,
- Fig. 33: in Detailansicht bzgl. des Bereiches Y von Fig. 30 und
- Fig. 34: in Detailansicht bzgl. des Bereiches X von Fig. 31.

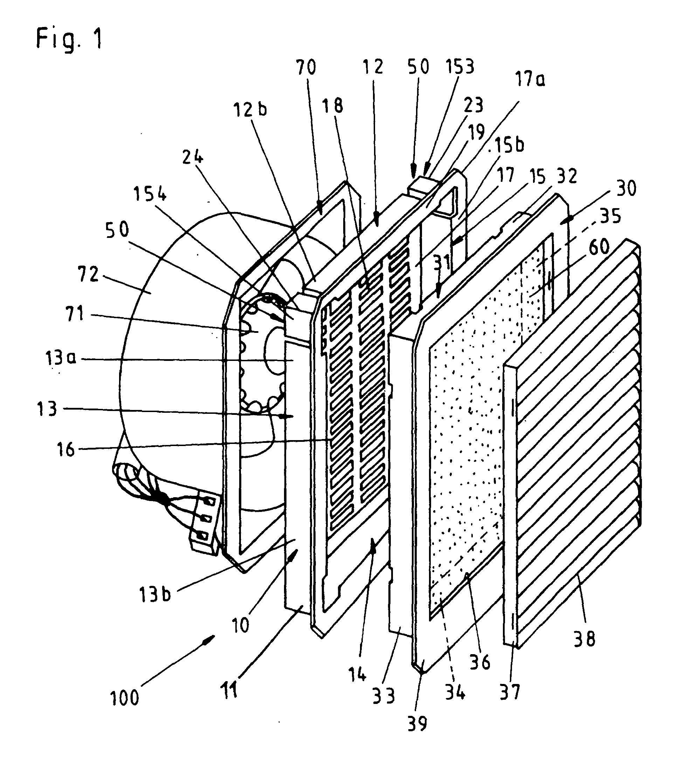

Der in den Fig. 1 bis 3 dargestellte und mit 100 bezeichnete Filterlüfter besteht aus einem Grundgehäuse 10 mit einer Schnellbefestigungseinrichtung 50 zur Befestigung des Filterlüfters 100 im Ausschnitt oder einer Durchbrechung einer Montagewand, einem in bzw. an dem Grundgehäuse 10 klemmend gehaltenen Abdeckgehäuse 30 mit einer mittels einer Abdeckplatte bzw. einem Designeinsatz 37 mit Lamellen und Luftschlitzen 38 abgedeckten Öffnung 36, einer in dem Abdeckgehäuse 30 angeordneten Filtermatte 60 und einem Gebläseträger 70 mit einem Gebläsegehäuse 71, welches auch in einem Gehäuse 72 angeordnet sein kann.

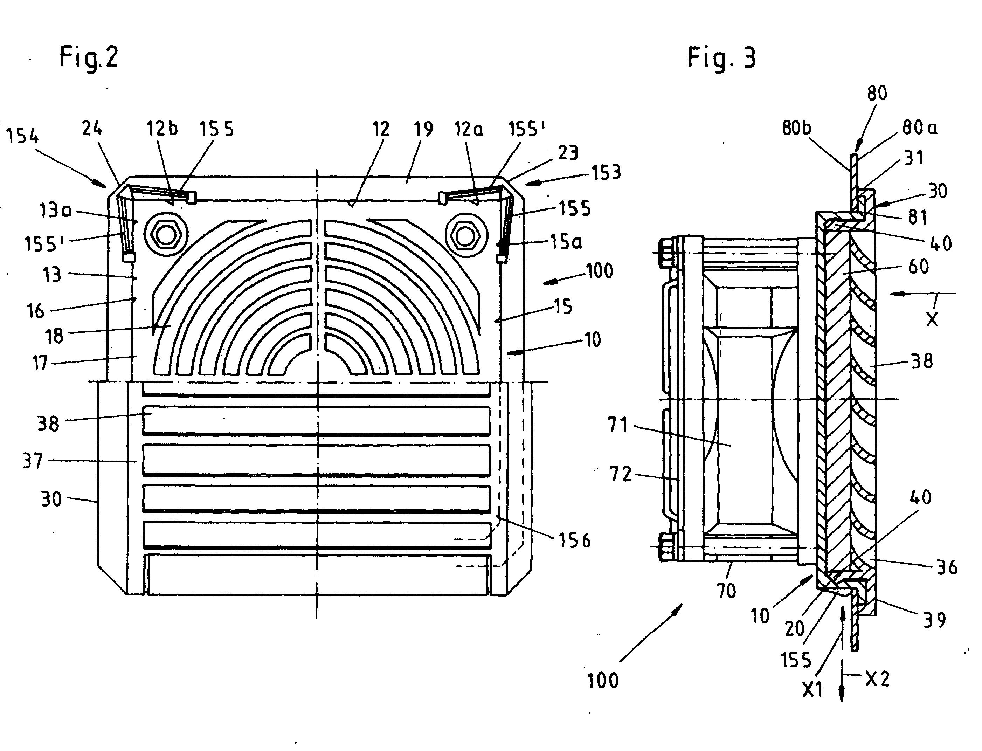

Das eine quadratische oder eine andere geometrische Form aufweisende Grundgehäuse 10 wird von einem Rahmen 11 mit vier Seitenwänden 12, 13, 14, 15 gebildet. Die Endbereiche der Seitenwände 12 bis 15 sind mit 12a, 13a und 13b, 14a und 14b und 15a und 15b bezeichnet (Fig. 1, 2).

Die von dem Rahmen 11 des Grundgehäuses 10 gebildete Rahmenöffnung bzw. Durchbrechung 16 ist mittels eines plattenförmigen Zuschnittes 17 mit Rippen verschlossen, der als Berührungsschutzgitter 18 ausgebildet ist (Fig. 1, 2), wobei die Rippen des Grundgehäuses 10 eine 45° Schräge aufweisen, wohingegen die Lamellen des Designeinsatzes 37 die Luftführung vorgeben.

Die Ausbildung und Gestaltung des Berührungsschutzgitters 18 kann beliebig gewählt sein; wesentlich ist, dass eine ausreichende Anzahl von Durchbrechungen für eine Luftleitung bzw. -führung gegeben ist. Der Rahmen 11 mit dem plattenförmigen Zuschnitt 17 stellt vorzugsweise ein Formteil dar. Die Befestigung des plattenförmigen Zuschnittes 17 an den Seitenwänden 12 bis 15 des Rahmens 11 erfolgt vorzugsweise im mittleren Bereich der Seitenwände 12 bis 15 unter Freilassung und Ausbildung von Flügelecken 153, 154 in zwei Eckbereichen 23, 24 des Rahmens 11, worauf nachstehend noch näher eingegangen wird.

Der plattenförmige Zuschnitt 17 ist bis über die Seitenwände 12 bis 15 des Rahmens 11 unter Ausbildung eines umlaufenden Abschnittes 17a verlängert. Dieser umlaufende Abschnitt 17a bildet die Anlagekante bzw. den Anlagerand 19 im Bereich der Durchbrechung der Montagewand. Dieser umlaufende Randabschnitt 17a kann auch als gesonderter Anschlagrahmen an den Seitenwänden 12 bis 15 angeformt und nicht integrierter Bestandteil des plattenförmigen Zuschnittes 17 sein. Der Rahmen 11 mit den Seitenwänden 12 bis 15 und dem plattenförmigen Zuschnitt 17 mit dem Berührungsschutzgitter 18 sowie mit der Montagewandanlagekante 19 bilden ein einstückiges Bauteil, welches z. B. im Spritzgussverfahren hergestellt ist.

Das an dem Grundgehäuse 10 mittels Klemmsitz gehaltene Abdeckgehäuse 30 bestehen aus einem Rahmen 31 mit den Seitenwänden 32, 33, 34, 35, wobei dieser Rahmen 31 in Form und Abmessungen denen des Rahmen 11 des Grundgehäuses entspricht. Die Abmessungen des Rahmens 31 sind dabei so gehalten, dass das Abdeckgehäuse 30 mit seinem Rahmen 31 in den vom Rahmen 11 des Grundgehäuses 10 gebildeten Innenraum einführbar ist. Die Seitenwände 32 bis 35 liegen bei in das Grundgehäuse 10 eingesetztem Abdeckgehäuse 30 an den Innenwandflächen der Seitenwände 12 bis 15 des Rahmens 11 des Grundgehäuses 10 an.

Die von dem Rahmen 31 des Abdeckgehäuses 30 gebildete Öffnung 36 ist mittels der Abdeckplatte bzw. dem Designeinsatz 37 abgedeckt, die bzw. der fester Bestandteil des Rahmens 31, jedoch auch ein selbständiges Bauteil sein kann, das dann mittels Klemmsitz oder anderer geeigneter Verbindungsmittel in bzw. an dem Rahmen 31 des Abdeckgehäuses 30 gehalten ist. Diese Abdeckplatte 37 ist mit einer Anzahl von Luftleitschlitzen 38 oder mit andersartig ausgebildeten Durchbrechungen für eine Luftleitung und -führung versehen. Die Ausbildung der Luftschlitze 38 in der Abdeckplatte 37 erfolgt vorzugsweise durch eine jalousieklappenartige Ausgestaltung der Abdeckplatte 37 mit feststehenden oder auch verstellbaren Klappen, wobei letztere Ausführungsform besonders vorteilhaft ist, wenn es sich um Filterlüfter 100 handelt, die größere Abmessungen aufweisen. Darüber hinaus besteht auch die Möglichkeit, die Abdeckplatte 37 mit andersartig ausgebildeten Durchbrechungen für eine Luftleitung bzw. -führung zu versehen; da nach erfolgtem Einbau des Filterlüfters 100 die Abdeckplatte 37 des auf das Grundgehäuse 10 aufgesetzten Abdeckgehäuses 30 eine Sichtfläche bildet, kann unter Ausbildung von Luftleitschlitzen oder Luftleitdurchbrechungen die Abdeckplatte 37 mit einem besonders gestalteten Design versehen sein.

Der Rahmen 31 des Abdeckgehäuses 30 ist mit einem senkrecht zu den Rahmenseitenwänden 32 bis 35 stehenden verlängerten Abschnitt versehen, der eine umlaufende Anlagekante 39 bildet, an der die Außenwandfläche des umlaufenden Abschnittes 17a des Rahmens 11 anliegt, wenn das Abdeckgehäuse 30 mit seinem Rahmen 31 in den Rahmen 11 des Grundgehäuses 10 eingeschoben ist. Die ausgebildete Anlagekante 39 des Rahmens 31 des Abdeckgehäuses 30 kann an den Seitenwänden 32 bis 35 des Rahmens 31 angeformt sein; es besteht jedoch auch die Möglichkeit, diesen umlaufenden und die Anlagekante 39 bildenden Wandabschnitt durch eine entsprechend bemessene Abdeckplatte 37 zu schaffen, deren Abmessungen dann größer sind als die Außenabmessungen des Rahmens 31. Der umlaufende Rand dieses verlängerten, die Anlagekante 39 bildenden Abschnittes kann darüber hinaus noch in Richtung zum Rahmen 31 abgebogen sein, um den umlaufenden Rand des Abschnittes 17a des Rahmens 11 des Grundgehäuses 10 zu übergreifen, wenn das Grundgehäuse 10 mit dem Abdeckgehäuse 30 verbunden ist.

Die Halterung des Abdeckgehäuses 30 an dem Grundgehäuse 10 erfolgt vermittels einer Klemmverbindung, die von an den Außenwandflächen der Seitenwände 32 bis 35 des Rahmens 31 des Abdeckgehäuses 30 ausgebildeten Nocken 40 und entsprechend angeordneten und ausgebildeten Vertiefungen 20 an den Innenwandflächen der Seitenwände 12 bis 15 des Rahmens 11 des Grundgehäuses 10 gebildet wird, so dass beim Einführen des Rahmens 31 des Abdeckgehäuses 30 in den Rahmen 11 des Grundgehäuses 10 die Nocken 40 an dem Rahmen 31 in die entsprechend profilierten Vertiefungen 20 am Rahmen 11 des Grundgehäuses 10 eingreifen (Fig. 3).

Der Rahmen 31 des Abdeckgehäuses 30 ist so bemessen, dass dieser eine in an sich bekannter Weise ausgebildete Filtermatte 60 aufnehmen kann, die einerseits an der Innenwandfläche der Abdeckplatte 37 und andererseits der Innenwandfläche des Berührungsschutzgitters 18 des Rahmens 11 des Grundgehäuses 10 anliegt, wenn das Grundgehäuse 10 mit dem Abdeckgehäuse 30 verbunden ist.

Die an dem Grundgehäuse 10 vorgesehene Schnellbefestigungseinrichtung 50 für den Filterlüfter 100 besteht aus in zwei Eckbereichen 23, 24 des Rahmens 11 des Grundgehäuses 10 ausgebildeten federnd-elastischen Flügelecken 153, 154. Jede Flügelecke 153, 154 wird von zwei im rechten Winkel zueinander stehenden, aus den Flächen der im Eckbereich 23, 24 aneinander grenzenden Rahmenseitenwände 12, 13 und 15, 12 und in Richtung zu den Eckbereichen 23, 24 aus den Ebenen der Rahmenseitenwände 12 bis 15 nach außen verlaufend herausgestellten, federnd-elastisch, flügelartigen Klemmabschnitten 155, 155' gebildet. Die Flügelecken 153 und 154 in den Eckbereichen 23 und 24 des Rahmens 11 sind alle gleich ausgebildet. Gleiche Ausbildung weisen auch die flügelartigen Klemmabschnitte 155, 155' der zwei Flügelecken 153 und 154 auf.

Die flügelartigen Klemmabschnitte 155 ,155' einer jeden Flügelecke 153 und 154 sind derart bemessen, dass zwischen deren oberen Kanten und der die umlaufende Montagewandanlagekante 19 bildenden Wandfläche 17a ein Zwischenraum ausgebildet ist.

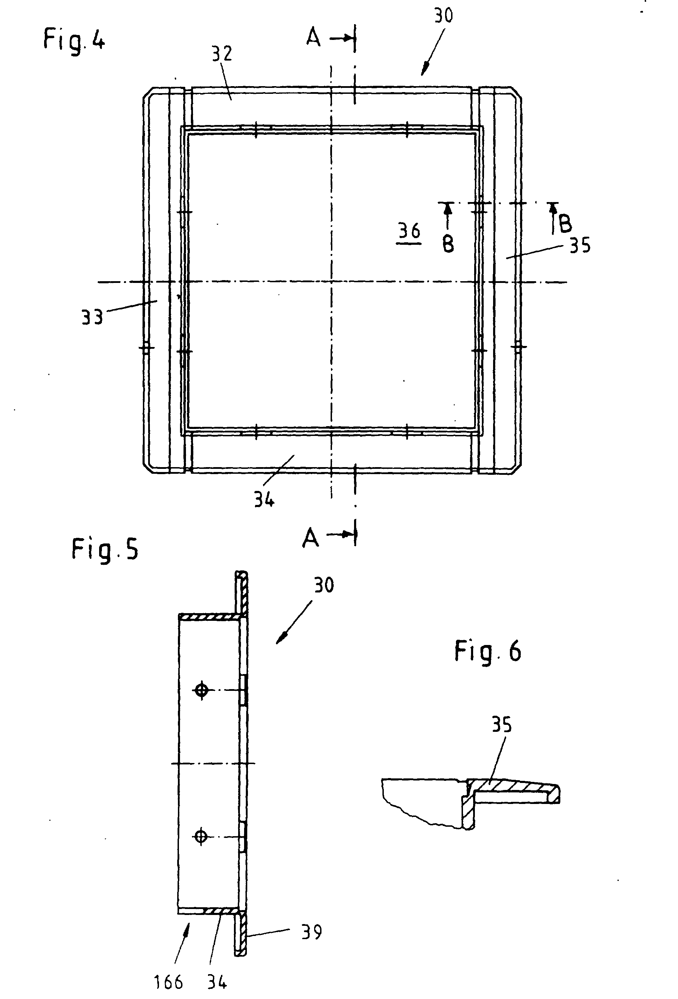

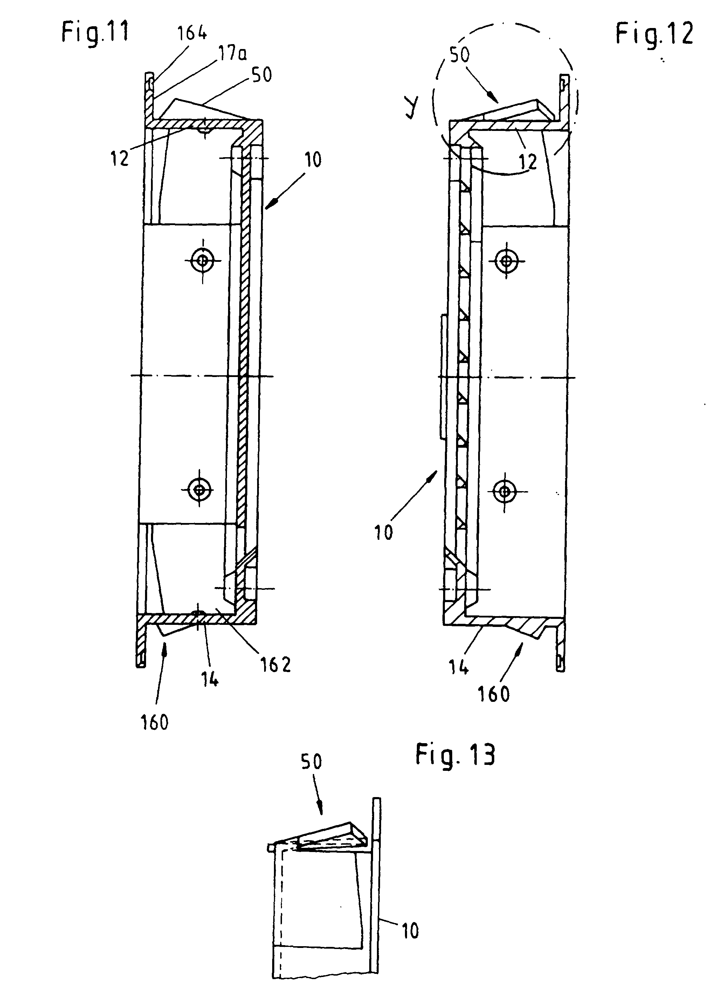

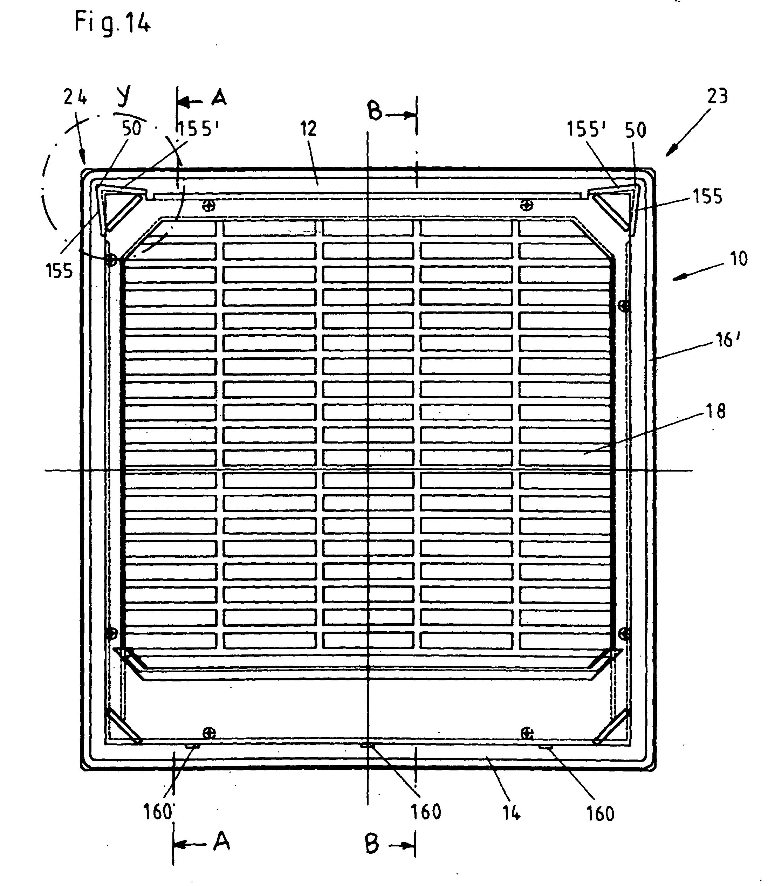

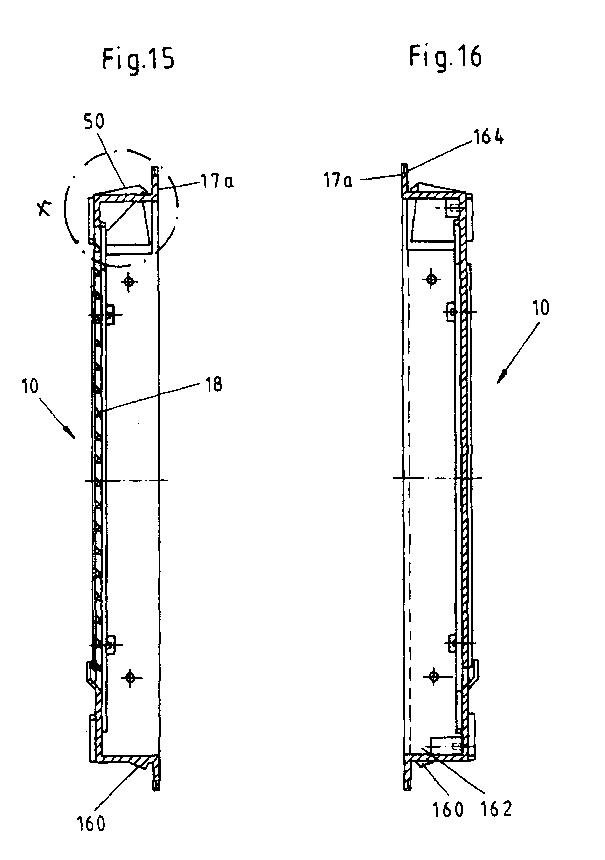

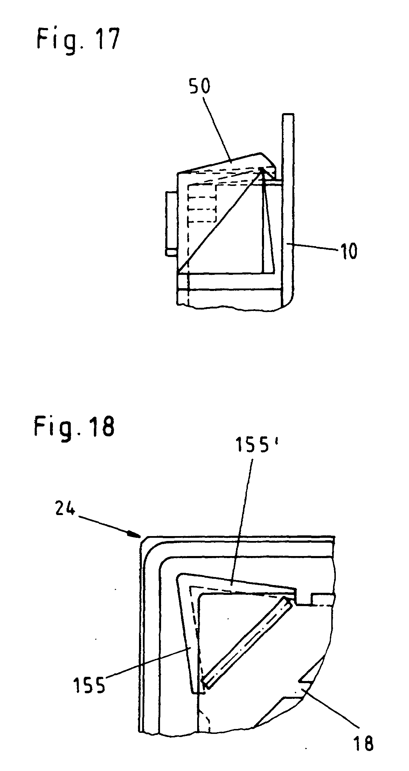

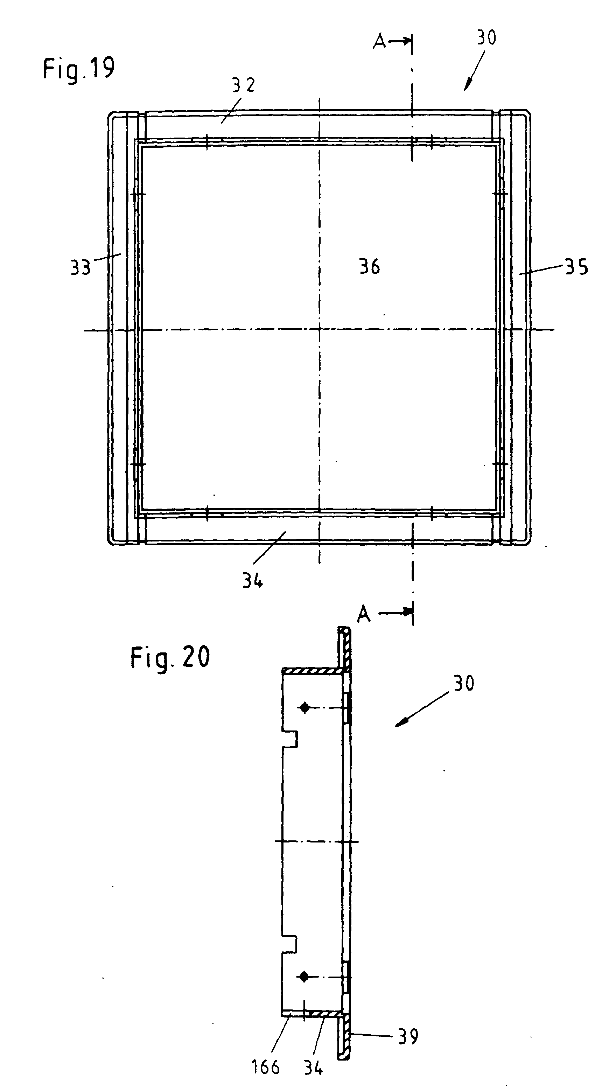

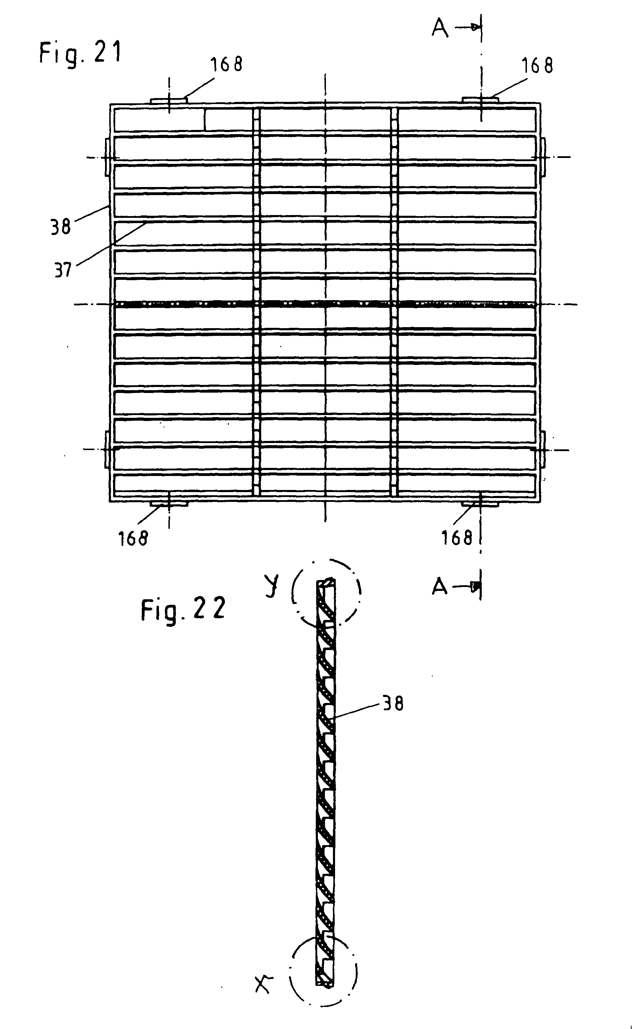

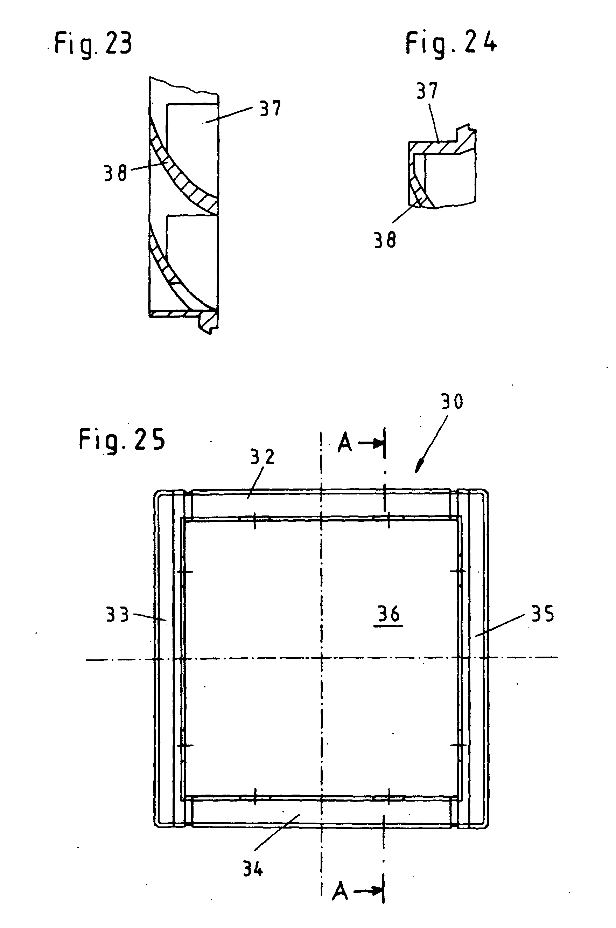

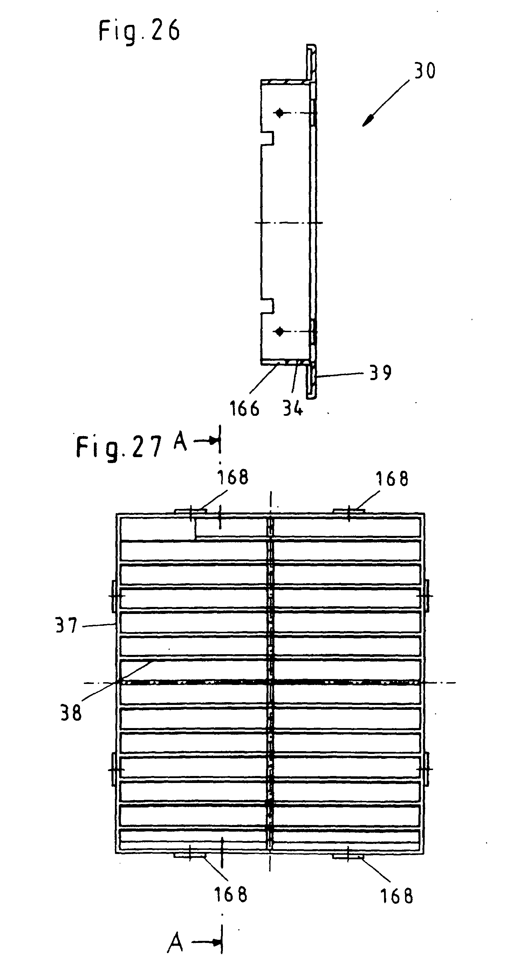

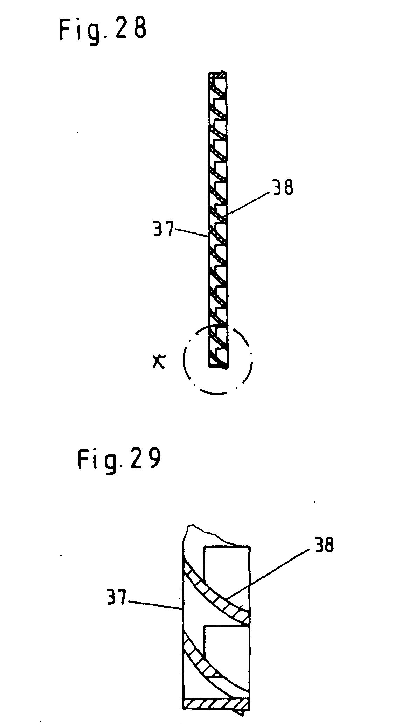

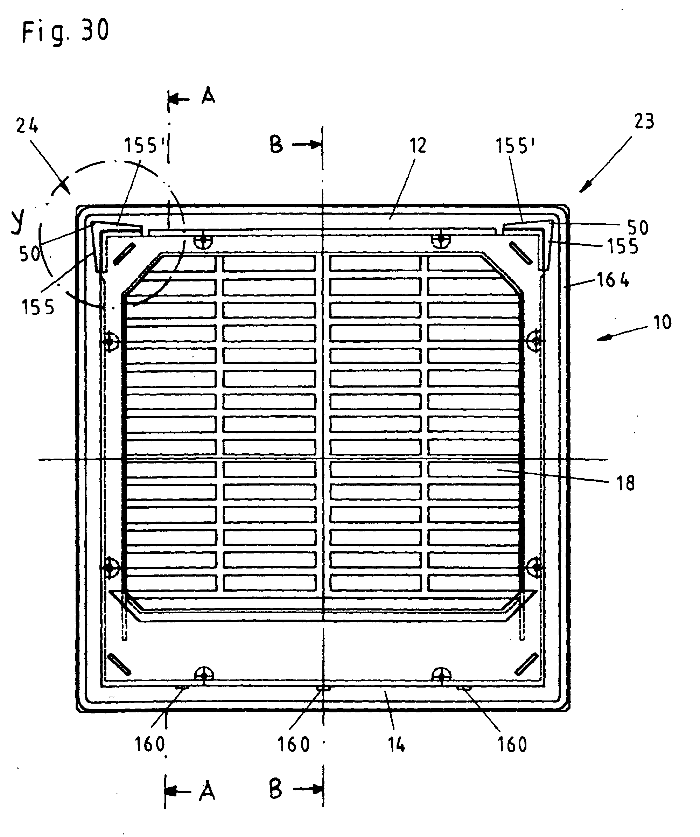

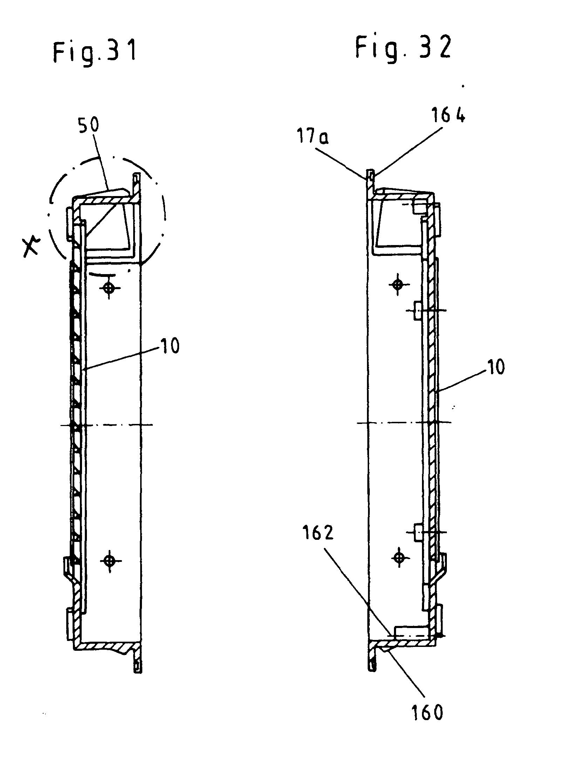

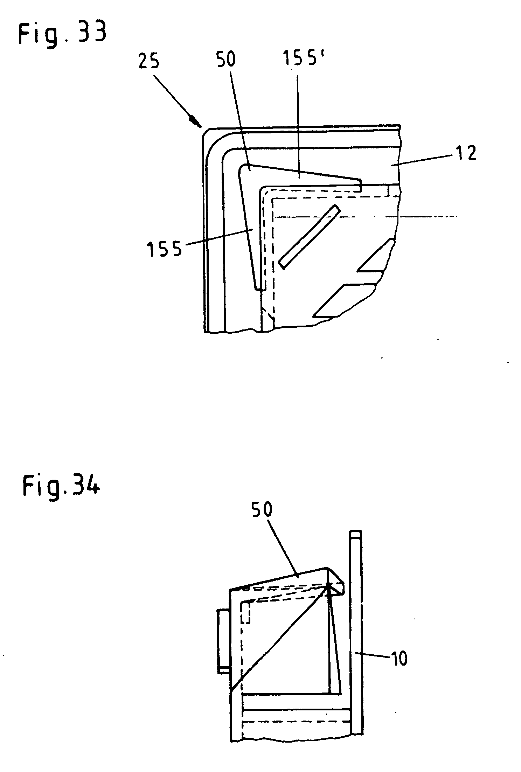

Die Fig. 4 bis 13 bzw. 14 bis 24 bzw. 25 bis 34 veranschaulichen jeweils die Bauteile von drei verschiedenen, bevorzugten Ausführungsformen einer erfindungsgemäßen Luftdurchtrittseinrichtung, wobei in diesen Fig. gleiche Bezugszeichen gleiche Teile bezeichnen. Da die erfindungswesentlichen Teile bei allen drei Ausführungsformen im Wesentlichen identisch sind, werden diese Teile nachfolgend unter Bezugnahme auf alle Fig. 4 bis 34 gemeinsam beschrieben. Darüber hinaus sind in den Fig. 4 bis 34 und in den Fig. 1 bis 3 gleiche Teile mit gleichen Bezugsziffern bezeichnet, so dass diese Teile nicht erneut beschrieben werden sondern auf die obige Erläuterung bzgl. der Fig. 1 bis 3 verwiesen wird.

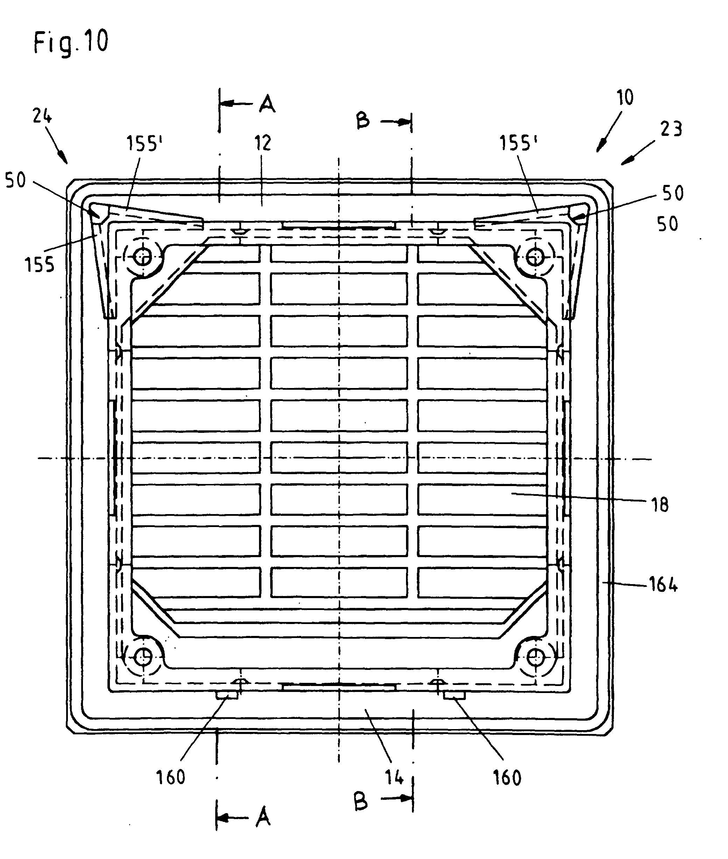

Das in Fig. 10 bis 13 bzw. 14 bis 18 bzw. 30 bis 34 dargestellte Grundgehäuse 10 umfasst neben den an zwei Ecken 23, 24 ausgebildeten Schnellbefestigungseinrichtung 50 mit federnd-elastischen, flügelartigen Klemmabschnitten 155, 155' an einer gegenüberliegenden Seite 14 des Grundgehäuses 10 zwei bzw. drei Klemm- bzw. Spannkeile 160, welche derart ausgebildet sind, dass diese an einem umlaufenden Rand einer Durchbrechung im Gehäuse einrasten, ohne dabei federnd elastisch beweglich zu sein. An dieser Seite 14 mit den Klemmkeilen 160 ist das Grundgehäuse 10 ferner mit einer Auffangwanne 162 für Kondenswasser ausgebildet. Zusätzlich weist das Grundgehäuse 10 eine umlaufende Nut 164 zum Einsetzten einer nicht dargestellten geschäumten Dichtung derart auf, dass bei in der Durchbrechung des Gehäuses angeordnetem Grundgehäuse 10 die Dichtung zwischen dem umlaufenden Abschnitt 17a des Grundgehäuses 10 und dem Gehäuse mit einer Vorspannung klemmend gehaltert ist und so eine entsprechende Abdichtung zwischen Gehäuse und Grundgehäuse 10 herstellt.

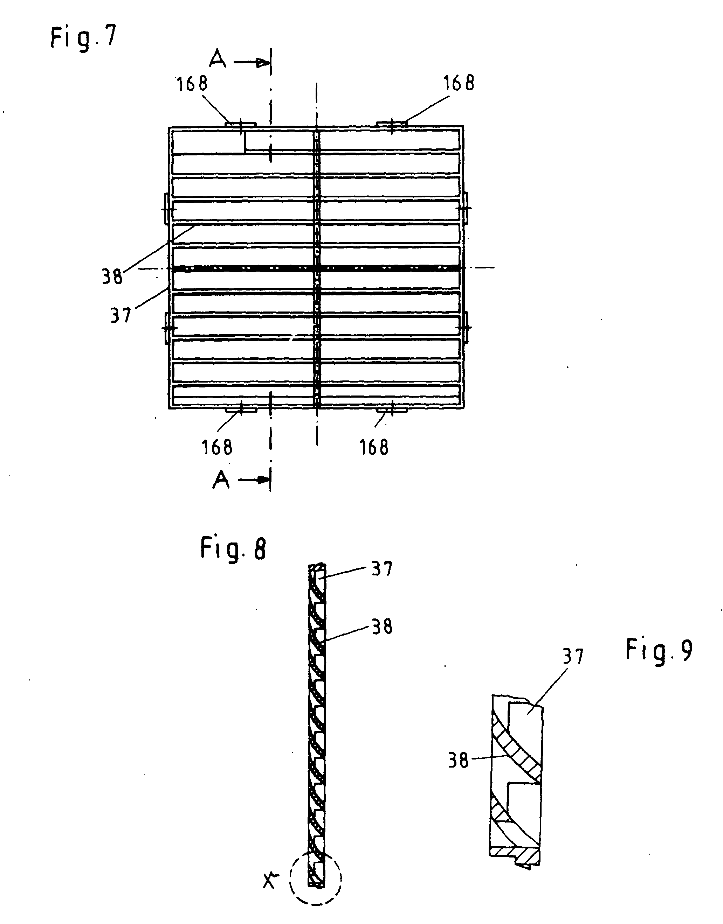

Das in Fig. 4 bis 6 bzw. 19/20 bzw. 25/26 dargestellte Abdeckgehäuse 30 mit Designeinsatz 37 (Fig. 7 bis 9 bzw. 21 bis 24 bzw. 27 bis 29) weist an seiner Seite 34 Wasserableitschlitze 166 auf die technisch als Verdrehsicherung für den Designdeckel dienen. Des weiteren dienen die Wasserableitschlitze zum Ableiten von Kondenswasser in die Auffangwanne 162 des Grundgehäuses 10.

Ferner sind die Rippen 38 des Designeinsatzes 37 angeschrägt ausgebildet, wie insbesondere aus Fig. 9 bzw. 23 bzw. 29 ersichtlich, um ein Eindringen von Wasser zu verhindern. Mit 168 sind am Designeinsatz 37 angeformte Federelemente zum Einklemmen in das Abdeckgehäuse 30 bezeichnet.

Das Grundgehäuse 10 und das Abdeckgehäuse 30 des Filterlüfters 100 bestehen vorzugsweise aus Kunststoffen, jedoch auch andersartige Werkstoffe können zur Herstellung dieser beiden Teile des Filterlüfters 100 herangezogen werden. Vorzugsweise werden solche Kunststoffe verwendet, die federnd-elastisch sind, um die federnd-elastische Wirkung der Flügelecken 153 und 154 bzw. deren flügelartige Klemmabschnitte 155, 155' zu bewirken. Es besteht jedoch auch die Möglichkeit, nur das Grundgehäuse 10 aus derartigen Kunststoffen herzustellen, da an dem Grundgehäuse 10 die Schnellbefestigungseinrichtung 50 angeordnet und ausgebildet ist. Wesentlich ist, dass die flügelartigen Klemmabschnitte 155, 155' federnd-elastisch sind und wenn diese aus ihrer Grundstellung herausbewegt worden sind, wieder in ihre Grundstellung selbsttätig zurückfedern.

Der Einbau des Filterlüfters 100 in die Wand 80 eines in der Zeichnung nicht dargestellten Schaltschrankes od. dgl. wird wie folgt durchgeführt:

Die Wand 80, an der der Filterlüfter 100 befestigt werden soll, wird mit einer der Querschnittsform des Filterlüfters 100 entsprechenden Durchbrechung 81 versehen (Fig. 3). Die Abmessungen dieser Durchbrechung 81 entsprechen den Außenabmessungen des Rahmens 11 des Grundgehäuses 10. In diese Durchbrechung 81 wird das Grundgehäuse 10 mit seinem Rahmen 11 eingeführt, so dass der Rahmen 11 mit einem Abschnitt durch die Durchbrechung 81 in der Montagewand 80 hindurchgeführt ist. Das Einschieben des Rahmens 11 des Grundgehäuses 10 in die Durchbrechung 81 der Montagewand 80 erfolgt in Pfeilrichtung X. Da die flügelartigen Klemmabschnitte 155, 155' der Schnellbefestigungseinrichtung 50 an dem Gehäuse 10 so ausgebildet und angeordnet sind, dass sich Gleitflächen ergeben, lässt sich der Rahmen 11 mühelos in die Durchbrechung 81 einführen, wobei gleichzeitig die flügelartigen Klemmabschnitte 155, 155' in Pfeilrichtung X1 in die Ebene der Seitenwände 12 bis 15 des Rahmens 11 gedrückt werden. Die Abmessungen der Durchbrechungen 81 in der Montagewand 80 sind so bemessen, dass im eingedrückten Zustand der flügelartigen Klemmabschnitte 155, 155' der zwei Flügelecken 153 und 154 in die von den Seitenwänden 12 bis 15 des Rahmens 11 gebildete Ebene eingedrückt werden, um den Rahmen 11 an den die Durchbrechung 81 begrenzenden Ränder hindurchführen zu können.

Kommt der Rahmen 11 des Grundgehäuses 10 mit seiner Ablagekante 19 zur Anlage an der Außenwandfläche 80a der Montagewand 80, dann haben die flügelartigen Klemmabschnitte 155, 155' eine Stellung erreicht, in der sie aus der niedergedrückten Stellung in ihre Ausgangsstellung zurückfedem, was in Pfeilrichtung X2 erfolgt, so dass die flügelartigen Klemmabschnitte 155, 155' dann die in Fig. 2 wiedergegebene Stellung einnehmen, in der eine Verriegelung des Grundgehäuses 10 an der Montagewand 80 erfolgt. An der den Klemmabschnitten 155, 155' gegenüberliegenden Seite 14 des Grundgehäuses 10 in der Durchbrechung 81, wobei bevorzugt diese Seite 14 zuerst in die Durchbrechung eingesetzt und dann die Klemmabschnitte 155, 155' eingesetzt werden. Der Gebläseträger 70 mit dem Gebläse 71 ist vor dem Einsetzen des Grundgehäuses 10 in die Durchbrechung 81 der Montagewand 80 bereits an dem Grundgehäuse 10 montiert, wobei die Abmessungen des Gebläseträgers 70 mit dem Gebläse 71 nicht über die Abmessungen des Rahmens 11 des Grundgehäuses 10 hinausgehen, so dass ein einwandfreies Hindurchführen des Gehäuseträgers 70 durch die Durchbrechung 81 in der Montagewand 80 beim Aufsetzen des Grundgehäuses 10 gewährleistet ist.

Nach der Verriegelung des Grundgehäuses 10 an der Montagewand 80 vermittels der flügelartigen Klemmabschnitte 155, 155' kann noch ein Nachzentrieren erfolgen, falls dies erforderlich sein sollte. Hieraufhin wird das Abdeckgehäuse 30 mit eingelegter Filtermatte 60 aufgesetzt, so dass der Rahmen 31 des Abdeckgehäuses 30 in den Innenraum des Rahmens 11 eingeführt wird. Es kommt dann die Klemmverbindung 20, 40 zum Einsatz, wodurch das Abdeckgehäuse 30 an dem Grundgehäuse 10 gehalten ist. Das Abdeckgehäuse 30 stützt sich dann mit seiner Anlagekante 39 an der Außenwandfläche 80a der Montagewand 80 ab.

Auch wenn die Montagewand 80 unterschiedliche Materialstärken aufweist, ist eine sichere Befestigung des Filterlüfters 100 an der Montagewand 80 möglich. Weist die Montagewand 80 eine größere Materialstärke auf, dann federn die flügelartigen Klemmabschnitte 155, 155' an den Eckbereichen des Gehäuses 10 nicht in ihre Ausgangsstellung zurück. Die Klemmabschnitte 155, 155' federn dann nur so weit zurück bis diese zur Anlage an der Montagewand 80 kommen. Aufgrund der durch das Rückfederungsvermögen gegebenen Kräfte wird der Filterlüfter 100 an der Montagewand 80 gehalten.

## Patentansprüche

1. Luftdurchtrittseinrichtung (100), insbesondere Filterlüfter oder Austrittsfilter, für den Einbau in eine Durchbrechung (81) in einer Wand (80) eines Gehäuses, insbesondere eines Gehäuses von Abwärme erzeugenden Bauteilen, eines Elektronikschrankes, eines Schaltschrankes, eines Gehäusesystems oder eines Computergehäuses, wobei die Luftdurchtrittseinrichtung (100) folgendes umfasst, ein Grundgehäuse (10), ein in bzw. an dem Grundgehäuse (10) klemmend gehaltenes Abdeckgehäuse (30) und eine in dem Abdeckgehäuse (30) gehaltene Filtermatte (60), wobei das Grundgehäuse (10) wenigstens ein Federelement (50) zum Eingriff in die Durchbrechung (81) der Wand (80) des Gehäuses aufweist,
**dadurch gekennzeichnet,**
**dass** das wenigsten eine Federelement (50) nur an der oberen Seite (12) des Grundgehäuses (10) und an der gegenüberliegenden unteren Seite (14) des Grundgehäuses (10) wenigstens ein Klemmkeil (160) derart angeordnet und ausgebildet sind, dass der bzw. die Klemmkeile (160) und das bzw. die Federelemente (50) zusammenwirkend mit einem umlaufenden Rand der Durchbrechung (81) der Wand (80) des Gehäuses die Luftdurchtrittseinrichtung (100) an der Wand (80) haltern.

2. Luftdurchtrittseinrichtung (100) nach Anspruch 1,
**dadurch gekennzeichnet,**
**dass** an einer in Einbaulage der Luftdurchtrittseinrichtung (100) in Schwerkraftrichtung unten liegenden Seite (14) des Grundgehäuses (10) eine Wanne (162) zur Aufnahme von Kondenswasser ausgebildet ist.

3. Luftdurchtrittseinrichtung (100) nach einem der Ansprüche 1 und 2,
**dadurch gekennzeichnet,**
**dass** an dem Grundgehäuse (10) gehäuseseitig eine umlaufende Nut (164) zur Aufnahme einer Dichtung derart vorgesehen ist, dass bei in der Durchbrechung (81) angeordnetem Grundgehäuse (10) die Dichtung zwischen der Wand (80) des Gehäuses und dem Grundgehäuse (10) unter einem vorbestimmten Anpressdruck gehalten ist, und
**dass** an einer in Einbaulage der Luftdurchtrittseinrichtung (100) in Schwerkraftrichtung unten liegenden Seite (14) des Grundgehäuses (10) eine Wanne (162) zur Aufnahme von Kondenswasser ausgebildet ist.

4. Luftdurchtrittseinrichtung (100) nach einem der Ansprüche 1 bis 3,
**dadurch gekennzeichnet,**
**dass** am Grundgehäuse (10) gegenüber des Abdeckgehäuses (30) ein Gebläseträger (70) mit einem Gebläse (71) angeordnet sein kann.

5. Luftdurchtrittseinrichtung (100) nach einem der Ansprüche 1 bis 4,
**dadurch gekennzeichnet,**
**dass** an dem Abdeckgehäuse (30) an einer vom Grundgehäuse (10) abgewandten Seite ein Designeinsatz (37) angeordnet ist.

6. Luftdurchtrittseinrichtung (100) nach Anspruch 5,
**dadurch gekennzeichnet,**
**dass** der Designeinsatz (37) Rippen (38) aufweist, welche derart geformt sind, dass das Eindringen von z. B. Regenwasser und ein Wasserstrom in Richtung der Wanne (162) im Grundgehäuse (10) weitgehend verhindert wird.

7. Luftdurchtrittseinrichtung (100) nach einem der Ansprüche 1 bis 6,
**dadurch gekennzeichnet,**
**dass** auf der Rückseite des Grundgehäuses (10) Rippen vorgesehen sind.

8. Luftdurchtrittseinrichtung (100) nach einem der Ansprüche 1 bis 7,
**dadurch gekennzeichnet,**
**dass** die Dichtung in der Nut (164) des Grundgehäuses (10) eine aufgeschäumte PU-Dichtung ist.

9. Luftdurchtrittseinrichtung (100) nach einem der Ansprüche 1 bis 8,
**dadurch gekennzeichnet,**
**dass** das Abdeckgehäuse (30) an einer der Wanne (162) im Grundgehäuse (10) und/oder der Designdeckel an einer der Wanne im Grundgehäuse zugewandten Seite (34) wenigstens eine Durchbrechung bzw. wenigstens einen Schlitz (166) aufweist.

10. Luftdurchtrittseinrichtung (100) nach einem der Ansprüche 1 bis 9,
**dadurch gekennzeichnet,**
**dass** die Wanne (162) an einer dem Gehäuse abgewandten Seite des Grundgehäuses (10) ausgebildet ist.

11. Luftdurchtrittseinrichtung (100) nach einem der Ansprüche 1 bis 10,
**dadurch gekennzeichnet,**
**dass** die Wanne (162) einstückig mit dem Grundgehäuse (10) ausgebildet ist.

12. Luftdurchtrittseinrichtung (100) nach einem der Ansprüche 1 bis 11,
**dadurch gekennzeichnet,**
**dass** das Grundgehäuse (100) rechteckig ausgebildet ist und zwei Federelemente (50) an zwei benachbarten Ecken (23, 24) einer Seite (12) des Grundgehäuses (10) angeordnet sind, welche in Einbaulage der Luftdurchtrittseinrichtung (100) in Schwerkraftrichtung oben liegt.

13. Luftdurchtrittseinrichtung (100) nach Anspruch 12,
**dadurch gekennzeichnet,**
**dass** an einer in Einbaulage der Luftdurchtrittseinrichtung in Schwerkraftrichtung unten liegenden Seite (14) des Grundgehäuses (10) zwei oder drei Klemmkeile (160) beabstandet von entsprechenden Ecken (21) dieser unten liegenden Seite (14) angeordnet sind.

14. Luftdurchtrittseinrichtung (100) nach einem der Ansprüche 1 bis 13,
**dadurch gekennzeichnet,**
**dass** das bzw. die Federelemente (50) und der bzw. die Klemmkeile (160) einstückig mit dem Grundgehäuse (10) ausgebildet sind.

## Claims

1. Device for the passage of air (100), particular filter fan or outlet filter, for fitting in an opening (81) in a wall (80) of a casing, in particular of a casing of waste heat producing components, of an electronic cupboard, of a switch cupboard, of a casing system or of a computer casing, whereby the device for the passage of air (100) comprises the following elements, a main casing (10), a covering casing (30) held clamped in or on the main casing (10) and a filter nat (60) held in the covering casing (30), whereby the basic casing (10) has at least one spring element (50) for engaging into the opening (81) of the wall (80) of the casing,
**characterized in**
**that** the at least one spring element (50) is placed and configured only on the upper side (12) of the main casing (10) and at least one clamping wedge (160) is placed and configured on the opposite lower side (14) of the main casing (10) in such a way that the clamping wedge(s) (160) and the spring element(s) (50) support the device for the passage of air (100) on the wall (80) by cooperating with a peripheral edge of the opening (81) of the wall (80) of the casing.

2. Device for the passage of air (100) according to claim 1,
**characterized in**
**that** a pan (162) for receiving condensation water is formed on one side (14) of the main casing (10) situated below in gravitation direction, the device for passage of air (100) being in fitting position.

3. Device for the passage of air (100) according to any of the claims 1 and 2,
**characterized in**
**that** a peripheral groove (164) for receiving a gasket is provided on the main casing (10) on the casing side in such a manner that, the main casing (10) being placed in the opening (81), the gasket is held between the wall (80) of the casing and the main casing (10) under a predetermined application pressure and that a pan (162) for receiving condensation water is formed on one side (14) of the main casing (10) situated below in gravitation direction, the device for passage of air (100) being in fitting position.

4. Device for the passage of air (100) according to any of the claims 1 to 3,
**characterized in**
**that** a blast support (70) with a blast (71) can be placed on the main casing (10) opposite the covering casing (30).

5. Device for the passage of air (100) according to any of the claims 1 to 4,
**characterized in**
**that** a design insert (37) is placed on the covering casing (30) on one side turned away from the main casing (10).

6. Device for the passage of air (100) according to claim 5,
**characterized in**
**that** the design insert (37) has ribs (38) which are formed in such a manner that the penetration of for example rain water and a water flow in direction of the pan (162) in the main casing (10) is avoided at a great extent.

7. Device for the passage of air (100) according to any of the claims 1 to 6,
**characterized in**
**that** ribs are provided on the rear side of the main casing (10).

8. Device for the passage of air (100) according to any of the claims 1 to 7,
**characterized in**
**that** the gasket in the groove (164) of the main casing (10) is a foamed polyurethane gasket.

9. Device for the passage of air (100) according to any of the claims 1 to 8,
**characterized in**
**that** the covering casing (30) has on one side (34) turned to the pan (162) in the main casing (10) and/or the design insert on one side (34) turned to the pan in the main casing at least one opening or at least one slit (166).

10. Device for the passage of air (100) according to any of the claims 1 to 9,
**characterized in**
**that** the pan (162) is configured on one side of the main casing (10) turned away from the casing.

11. Device for the passage of air (100) according to any of thee claims 1 to 10,
**characterized in**
**that** the pan (162) is configured in one piece with the main casing (10).

12. Device for the passage of air (100) according to any of the claims 1 to 11,
**characterized in**
**that** the main casing (100) is configured rectangular and two spring elements (50) are placed at two neighbouring corners (23, 24) of one side (12) of the main casing (10) which is situated uppermost in gravitation direction, the device for the passage of air (100) being in fitting position.

13. Device for the passage of air (100) according to claim 12,
**characterized in**
**that** two or three clamping wedges (160) are placed on one side (14) of the main casing (10) which is situated below in gravitation direction, the device for the passage of air being in fitting position, at a distance of corresponding corners (21) of this side (14) situated below.

14. Device for the passage of air (100) according to any of the claims 1 to 13,
**characterized in**
**that** the spring element(s) (50) and the clamping wedge(s) (160) are configured in one piece with the main casing (10).

## Revendications

1. Dispositif de passage d'air (100), en particulier aérateur à filtre ou filtre de sortie, pour le montage dans une découpure (81) dans une paroi (80) d'un boîtier, en particulier d'un boîtier de composants produisant de la chaleur perdue, d'une armoire électronique, d'une armoire de commande, d'un système de boîtier ou d'un boîtier d'ordinateur, le dispositif de passage d'air (100) comprenant les éléments suivants, un boîtier de base (10), un boîtier de recouvrement (30) maintenu coïncé dans ou sur le boîtier de base (10) et une natte de filtrage (60) maintenue dans le boîtier de recouvrement (30), le boîtier de base (10) présentant au moins un élément de ressort (50) pour l'engrènement dans la découpure (81) de la paroi (80) du boîtier,
**caractérisé en ce**
**que** l'élément de ressort qui existe au moins (50) n'est placé et configuré que sur le côté supérieur (12) du boîtier de base (10) et sur le côté inférieur opposé (14) du boîtier de base (10) au moins un coin de serrage (160) est placé et configuré de telle manière que le ou les coin(s) de serrage (160) et l'élément ou les éléments de ressort (50) maintiennent le dispositif de passage d'air (100) au mur (80) en coopérant avec un bord périphérique de la découpure (81) du mur (80) du boîtier.

2. Dispositif de passage d'air (100) selon la revendication 1,
**caractérisé en ce**
**qu'**une cuvette (162) pour recevoir de l'eau de condensation est configurée sur un côté (14) du boîtier de base (10) qui est situé en bas dans le sens de la gravité lorsque le dispositif de passage d'air (100) est en position de montage.

3. Dispositif de passage d'air (100) selon l'une des revendications 1 et 2,
**caractérisé en ce**
**qu'**une rainure périphérique (164) pour loger une étanchéité est prévue sur le boîtier de base (10) du côté du boîtier de telle manière que, lorsque le boîtier de base (10) est placé dans la découpure (81), l'étanchéité est maintenue entre la paroi (80) du boîtier et le boîtier de base (10) avec une pression d'appui prédéfinie et
**qu'**une cuvette (162) pour recevoir de l'eau de condensation est configurée sur un côté (14) du boîtier de base (10) qui est situé en bas dans le sens de la gravité lorsque le dispositif de passage d'air (100) est en position de montage.

4. Dispositif de passage d'air (100) selon l'une des revendications 1 à 3,
**caractérisé en ce**
**qu'**un support de soufflante (70) avec une soufflante (71) peut être placé sur le boîtier de base (10) en face du boîtier de recouvrement (30).

5. Dispositif de passage d'air (100) selon l'une des revendications 1 à 4,
**caractérisé en ce**
**qu'**un insert design (37) est placé sur le boîtier de recouvrement (30) sur un côté détourné du boîtier de base (10).

6. Dispositif de passage d'air (100) selon la revendication 5,
**caractérisé en ce**
**que** l'insert design (37) présente des nervures (38) qui sont formées de telle manière que la pénétration par exemple d'eau de pluie et un flux d'eau en direction de la cuvette (162) dans le boîtier de base (10) est évité dans une grande mesure.

7. Dispositif de passage d'air (100) selon l'une des revendications 1 à 6,
**caractérisé en ce**
**que** des nervures sont prévues au dos du boîtier de base (10).

8. Dispositif de passage d'air (100) selon l'une des revendications 1 à 7,
**caractérisé en ce**
**que** l'étanchéité dans la rainure (164) du boîtier de base (10) est une étanchéité en polyuréthane expansé.

9. Dispositif de passage d'air (100) selon l'une des revendications 1 à 8,
**caractérisé en ce**
**que** le boîtier de recouvrement (30) présente, sur un côté (34) tourné vers la cuvette (162) dans le boîtier de base (10), et/ou le couvercle design, sur un côté (34) tourné vers la cuvette dans le boîtier de base, au moins une découpure ou au moins une fente (166).

10. Dispositif de passage d'air (100) selon l'une des revendications 1 à 9,
**caractérisé en ce**
**que** la cuvette (162) est configurée sur un côté du boîtier de base (10) qui est détourné du boîtier.

11. Dispositif de passage d'air (100) selon l'une des revendications 1 à 10,
**caractérisé en ce**
**que** la cuvette (162) est configurée en une pièce avec le boîtier de base (10).

12. Dispositif de passage d'air (100) selon l'une des revendications 1 à 11,
**caractérisé en ce**
**que** le boîtier de base (100) est configuré à angles droits et deux éléments de ressort (50) sont placés aux deux coins voisins (23, 24) d'un côté (12) du boîtier de base (10) qui se situe en haut dans le sens de gravité lorsque le dispositif de passage d'air (100) est en position de montage.

13. Dispositif de passage d'air (100) selon la revendication 12,
**caractérisé en ce**
**que** deux ou trois coins de serrage (160) sont placés sur un côté (14) du boîtier de base (10) qui est situé en bas dans le sens de gravité, lorsque le dispositif de passage d'air est en position de montage, en étant distancés des coins correspondants (21) de ce côté situé en bas (14).

14. Dispositif de passage d'air (100) selon l'une des revendications 1 à 13,
**caractérisé en ce**
**que** l'élément de ressort ou les éléments de ressort (50) et le coin de serrage ou les coins de serrage (160) sont configurés en une pièce avec le boîtier de base (10).
